# EUROPEAN PATENT APPLICATION

(11) **EP 1 355 347 A2**
(43) Date of publication of application: **22.10.2003**
(21) Application number: 03252169.2
(22) Date of filing: 04.04.2003
(51) Int. Cl.: H01L 21/00

(54) **Workpiece holder for semiconductor manufacturing apparatus**

(30) Priority: 15.04.2002 JP 2002111515
(71) Applicant: Sumitomo Electric Industries, Ltd., Osaka-shi, Osaka 541-0041 (JP)
(72) Inventor: Kuibira, Akira, Sumitomo Elec. Industr. Ltd, Itami-shi, Hyogo (JP); Natsuhara, Masuhiro, Sumitomo Elec. Industr. Ltd, Itami-shi, Hyogo (JP); Nakata, Hirohiko, Sumitomo Elec. Industr. Ltd, Itami-shi, Hyogo (JP)
(74) Representative: Cross, Rupert Edward Blount

(57) **Abstract**

Semiconductor-manufacturing-apparatus workpiece holder whose wafer-retaining surface is superior in isothermal properties, and that is suitable for use in thermosetting of photolithographic photoresists in coater/developers, and in baking of low dielectric constant, i.e. low-*k*, insulating films. The workpiece holder is made up of a wafer holder 1, and a support member 4 that supports the wafer holder 1, and features the thermal conductivity of the support member 4 being lower than the thermal conductivity of the wafer holder 1. The wafer holder 1 and the support member 4 either are not joined, or if joined are made to have a difference in thermal expansion coefficient of 2.0 × 10⁻⁶/°C or less. The chief component of the wafer holder 1 preferably is AlN, and of the support member 4, mullite.

## Description

The present invention relates to workpiece holders employed in semiconductor manufacturing apparatuses, and relates in particular to semiconductor-manufacturing-apparatus workpiece holders suited to applications in thermosetting of photolithographic photoresists in coater/developers, and in heating/baking of low-dielectric-constant, i.e. low-*k*, insulating films.

As semiconductors have become more highly integrated and miniaturized in semiconductor manufacturing in recent years, the metal wiring (interconnect) linewidth of, and the inter-line spacing in, aluminum or copper circuits on silicon wafers formed by aluminum sputtering or copper plating have become narrow year to year.

The interconnect patterns for aluminum or copper circuits are formed by a photolithographic technique. For example, a negative-pattern photoresist is formed onto an aluminum interconnect film by coating a resin uniformly onto the aluminum film, and thereafter imprinting a pattern into the photoresist with an exposure device called a stepper, and thermosetting the photoresist to remove unneeded areas. A patterned aluminum interconnect is then obtained by etching the aluminum film along the negative pattern areas with an etching device and removing the photoresist.

Inasmuch as bringing interconnect lines closer together leads to occurrence of interaction between signals in the lines, interaction between interconnect lines must be eliminated by filling between interconnects and between laminated layers with a low-dielectric-constant insulating material. While silicon oxide had been conventionally employed as an insulating material for this purpose, materials known as low-*k* dielectrics have also come to be used as low-dielectric-constant insulating films.

A low-*k* insulating film is formed by a method according to which a raw material for the film is dissolved into a slurry that is spin-coated to produce a uniform layer in which a pattern is formed using a photolithographic technique likewise as noted above, and thereafter which is hardened by baking in a heater.

A heater using a resistive heating element that is a stainless steel foil sandwiched between quartz plates is an example of heaters that have been employed in thermosetting photolithographic films, and in baking low-dielectric-constant insulating films, as in the foregoing. Nevertheless, owing to problems with the isothermal properties and durability of the heaters, an isothermally superior and highly durable heating device has been desired.

Meanwhile, heaters made of ceramics in which a molybdenum coil is embedded into highly thermoconductive, highly anticorrosive AlN or Si₃N₄ have been used in the CVD devices employed in forming a variety of thin films. Such heaters of ceramic manufacture are joined on the backside of the wafer-retaining surface to one end of a tubular aluminum support member the other end of which is supported O-ring sealed in a chamber. Furthermore, electrode terminals and electrode-supply lead lines, the corrosion resistance of which is low, are housed on the inside of the tubular aluminum support member so as not to be exposed to the corrosive gases used within the chamber.

Scaling-up the size of silicon wafers in order to reduce costs in semiconductor fabrication has been ongoing, with a changing over of late from 8-inch to 12-inch. Consequently, calls for enhanced isothermal properties in the heaters employed in thermosetting photolithographic resist films, and in baking low-*k* dielectric insulating films, have been on the rise. Demands in particular have been that the isothermal rating in the wafer-retaining surface of the heaters be within ±1.0%, more desirably within ±0.5%.

The wafer holder and the support member in heaters made of ceramic are in most cases joined, in order to stabilize the wafer holder and to protect the electrode terminals from the atmosphere within the chamber. If in such cases the thermal expansion coefficient of the wafer holder and the support member were to differ, in temperature-elevating and cooling processes thermal stress due to the difference in thermal expansion coefficient between the materials would arise and produce cracking in the ceramic, which is the more fragile material. Consequently, wafer holders and support members in which like materials are used are joined.

Nevertheless, if a material of high thermal conductivity is utilized in the wafer holder to heighten the isothermal properties of the wafer-retaining surface, since the support member must also be a material of the same high thermal conductivity, the heat generated by the resistive heating element in the wafer holder would escape extremely effectively via the high-thermal-conductivity support member. The temperature of the wafer holder would consequently drop significantly in the area where it is joined with the support member, which could not but lower the isothermal rating of the wafer holder.

Again, with the wafer holder being joined with a support member of low thermal conductivity and thermal expansion coefficient that differs from that of the wafer holder―in order to keep its isothermal rating from deteriorating due to heat escaping to the support member to which it is joined―has been the problem that cracks caused by thermal stress owing to the difference in thermal expansion coefficient appear in the wafer holder made of ceramic, the more fragile material.

Furthermore, in order to lower the temperature of the location in which the support member is installed and prevent thermal degradation of the materials on the chamber end, the vicinity of where in the chamber the support member is installed is routinely cooled, with water or the like. If in such cases the support member were short, the temperature gradient would be sharp and consequently the support member would break easily from the thermal shock. In order to prevent cracking due to thermal shock, lengthening the support member to 300 mm or so ordinarily has been necessary, and accordingly the height of the chamber in which it is housed cannot but be large, which has been a constraint on miniaturization of the apparatus overall.

An object of the present invention, in view of such circumstances to date, is to realize a semiconductor-manufacturing-apparatus workpiece holder whose wafer-retaining surface is superior in isothermal properties, and that is suitable for use in thermosetting of photolithographic photoresists in coater/developers, and in baking of low dielectric constant, i.e. low-*k*, insulating films.

In order to achieve the foregoing objective, a retaining member that the present invention realizes for use in a semiconductor manufacturing apparatus is composed of a wafer holder made of a ceramic having a resistive heating element, and a support member for supporting the wafer holder; and is characterized in that the thermal conductivity of the support member is lower than the thermal conductivity of the wafer holder.

A semiconductor-manufacturing-apparatus retaining member by the present invention as noted above may be characterized in that the wafer holder and the support member either are not joined, or otherwise the wafer holder and the support member are joined and moreover the thermal expansion coefficient of the two is 2.0 × 10⁻⁶/°C or less.

Further, a semiconductor-manufacturing-apparatus retaining member by the present invention as in the foregoing may be characterized in that at least one ceramic type selected from AlN, Al₂O₃, SiC, Si₃N₄ is the principal component of the wafer holder.

A semiconductor-manufacturing-apparatus retaining member by the present invention as noted above may be characterized in that mullite is the principal component of the support member, and particularly in that the support member is preferably a composite of mullite and alumina.

In addition, the present invention realizes a semiconductor manufacturing apparatus utilizing any of the foregoing semiconductor-manufacturing-apparatus retaining members. Likewise, semiconductor manufacturing apparatus that the present invention realizes is an apparatus utilized in thermosetting of photolithographic resin films, or in baking low-dielectric-constant insulating films.

As determined by the present invention, for a semiconductor manufacturing apparatus a workpiece holder in which the isothermal rating of the workpiece-retaining face can be brought within ±1.0%, and more preferably within ±0.5%, and that enables miniaturization of the apparatus overall, can be realized. The semiconductor-manufacturing-apparatus workpiece holder is suitable for use in thermosetting of photolithographic photoresists in coater/developers, and in baking of low dielectric constant, i.e. low-*k*, insulating films.

From the following detailed description in conjunction with the accompanying drawings, the foregoing and other objects, features, aspects and advantages of the present invention will become readily apparent to those skilled in the art.

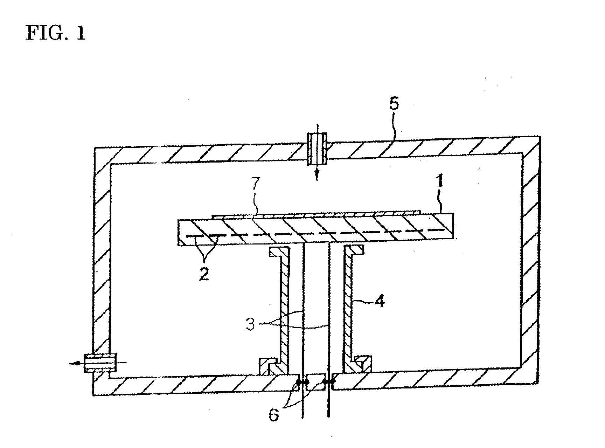

Fig. 1 is a schematic sectional view illustrating a wafer holder by the present invention, having been fixed to the interior of a chamber.

In the course of manufacturing semiconductors, the processes of thermosetting the photolithographic resists employed in the coater/developer, and of low-*k* baking―differing from CVD devices and etching devices using corrosive gases containing halogens―use He, Ar, N₂ and H₂ gases as the atmosphere. Consequently, inasmuch as the electrodes will not corrode even if their chief component is a material that is easily corroded by halogens, chamber contamination problems will not arise.

Accordingly, with semiconductor-manufacturing apparatuses that employ a non-corrosive atmosphere the support member does not necessarily have to be tubular to house therein the heater electrode terminals and the lead lines with which the wafer holder is provided, nor segregated and completely sealed off from the chamber interior atmosphere. Inasmuch as forming a gastight joint between the wafer holder and the support body is therefore not essential, it is possible not to join the wafer holder to the support body, and for example support it merely by setting it atop the support body.

Insofar as the wafer holder and the support member are not joined, heat generated by the resistive heating element in the wafer holder thus may be curbed from escaping through the support member, which in the present invention means that combined with the thermal conductivity of the support member being lower than the thermal conductivity of the wafer holder, enables the isothermal properties of the wafer holder to be substantially enhanced. What is more, because the wafer holder and the support member are not joined, they are not in the least subjected to thermal stress and there is no risk that the wafer holder of ceramic manufacture will break.

From the viewpoint of curbing the escape of heat through the support member, the wafer holder and the support member are best not joined but simply arranged with, e.g., the one placed on the other as noted above. Nevertheless, in order to stabilize the wafer holder and to protect the electrode terminals exposed in the wafer holder from the atmosphere in the chamber, in some cases the wafer holder and the support member are preferably fixed by joining them together.

If in such a case the thermal expansion coefficient of the wafer holder and of the support member differ significantly, thermal stress from the difference in the amount by which they thermally expand and contract will be produced in the joint, putting cracks in the ceramic that is the more susceptible material. To guard against this in a situation in which the wafer holder and the support member are joined, the difference in thermal expansion coefficient between the wafer holder and the support member may be made 2.0 × 10⁻⁶/°C or less to curb thermal stress produced by differences in thermal expansion/contraction amount and make it possible during heat cycling to control breakage due to thermal stress.

Whether the wafer holder and the support member are not joined or whether the wafer holder and the support member are joined, in either case noted above, in order to raise the isothermal rating of the wafer holder and shorten the length of the support member, preferably a material whose thermal conductivity is as high as possible―whose thermal conductivity is at least higher than that of the support member―is utilized for the wafer holder; and at the same time, a material whose thermal conductivity is as low as possible is utilized for the support member.

From the perspectives of high thermal expansion coefficient, heat resistance, and insulating properties, the wafer-holder material is preferably at least one ceramic type selected from AlN, Al₂O₃, SiC, Si₃N₄. Among these AlN, with a particularly high thermal conductivity, and superior heat and corrosion resistance, is especially preferable.

Wherein AlN is utilized for the wafer holder a material whose chief component is mullite (3Al₂O₃ · 2SiO₂)―possessing a 4.0 × 10⁻⁶/°C thermal expansion coefficient that is near the 4.5 × 10⁻⁶/°C thermal expansion coefficient of AlN―is preferably utilized as the support-member material. The fact that mullite, with its thermal conductivity being an extremely low 4 W/mK, is greatly effective in curbing the escape of heat enhances the isothermal properties of the wafer holder all the more. Moreover, although the length of the support member is made shorter, with the temperature gradient of the wafer holder, the support member, and their containment installation not growing severe, the fact that breakage in the support member due to thermal shock may be curbed enhances the reliability.

The thermal expansion coefficient of the support member can moreover be adjusted by adding alumina (Al₂O₃) to the mullite, to make it approximate the thermal expansion coefficient of the AlN constituting the wafer holder. Utilizing a support member in which the thermal expansion coefficient has been adjusted to about 4.5 × 10⁻⁶/°C for example by adding alumina to the mullite drastically reduces thermal stress on the joint between the wafer holder and the support member, in which, though subjected to cooling after being joined and to heat cycling in rising and falling temperatures, thermal stress therefore can be sharply diminished and reliability considerably enhanced.

### Embodiment 1

A granulated powder was prepared by adding 0.5 weight % yttrium oxide (Y₂O₃) as a sintering promoter to aluminum nitride (AlN) powder, further dispersing and mixing an additive organic binder into the Y₂O₃-containing AlN powder, and then spray-drying the mixture to granulate it. After being sintered the granulated powder was molded with a uniaxial press into 2 plates whose dimensions were 350 mm diameter × 5 mm thickness. This molded material was degreased within a nitrogen gas stream at a temperature of 800°C and sintered 6 hours at a temperature of 1900°C in a nitrogen gas stream. The thermal conductivity of the AlN sintered members thus produced was 180 W/mK. The 2 plates of the sintered material were superficially polished using diamond grit.

A resistive-heating-element circuit was imprinted onto one of the AlN sintered-material plates using a tungsten slurry that was a kneaded mixture of tungsten powder to which a sintering promoter and an ethyl-cellulose binder were added. The printed AlN plate was then degreased within a nitrogen gas stream at 900°C and developed by heating it 1 hour at 1850°C. A slurry that was a kneaded mixture glass for binding, to which an ethyl-cellulose binder was added, was spread onto the remaining sintered member, which was degreased within a nitrogen gas stream at 900°C.

The binding-glass surface and the resistive-heating-element surface of these two plates of AlN sintered material were stacked and, while placed under a 50 g/cm² load to prevent misalignment, were joined by heating 2 hours at 1800°C, whereby a wafer holder 1 made of AlN in the interior of which a resistive heating element 2 was embedded, as illustrated in Fig. 1, was fabricated. Electrode terminals (not illustrated) connecting to the interior resistive-heating element 2 were joined onto the backside of this wafer holder 1, also onto which power-supplying lead lines 3 electrically connected to a system-external power source were joined.

A cylindrical support member 100 mm × outside diameter × 90 mm inside diameter × 100 mm length and made from mullite (3Al₂O₃ · 2SiO₂) was prepared as a support member for supporting the wafer holder. The thermal conductivity of this support member of mullite manufacture was 4 W/mK. As indicated in Fig. 1, one end of this support member 4 was clamped to the chamber 5, and the wafer holder 1 was set on top of, without being joined to, the support member 4. Here, the lead lines 3 from the wafer holder 1, housed within the support member 4, were sealed with an O-ring 6 between them and the chamber 5.

The chamber 5 interior was reduced to 0.1 torr in pressure under an N₂ atmosphere, heated to 500°C by supplying power to the resistive heating element 2 from without the system, and while water-cooling the end of the support member 4 fixed to the chamber 5, the isothermal rating of the entire surface of the wafer holder 1 face retaining a wafer 7 was measured, and therein was 500°C ±0.39%. 10 identical wafer holders were fabricated, and put through a heat-cycling test raising and lowering the temperature 500 times between room temperature and 500°C, and yet there were no problems with all 10 of the holders following the heat cycling.

The conventional support member, moreover, with a length of 300 mm has necessitated a chamber some 450 mm in height to accommodate it. In contrast, in Embodiment 1, the support member 4 may be employed without any problems even shortened to 100 mm in length, enabling the height of the chamber 5, at 250 mm, also to be made compact.

### Embodiment 2

A granulated powder was prepared by adding 2 weight % magnesia (MgO) as a sintering promoter to aluminum oxide (Al₂O₃) powder, further dispersing and mixing an additive binder into the MgO-containing Al₂O₃ powder, and then spray-drying the mixture to granulate it. After being sintered the granulated powder was molded with a uniaxial press into 2 plates whose dimensions were 350 mm diameter × 5 mm thickness.

A resistive-heating-element circuit was imprinted onto one among the aforementioned molded members with a kneaded mixture of tungsten powder to which a sintering promoter and an ethyl-cellulose binder were added. The printed molded member was then degreased within an atmospheric air stream at 700°C, and at the same time was sintered by heating it 3 hours at 1600°C. The thermal conductivity of the Al₂O₃ sintered member thus produced was 20 W/mK. The sintered member was superficially polished using diamond grit.

The remaining molded member was sintered in the same manner as noted above, and a slurry that was a kneaded mixture glass for binding, to which an ethyl-cellulose binder was added, was spread onto to the sintered remaining molded member, which was degreased within an atmospheric air stream at 900°C. The binding-glass surface and the resistive-heating-element surface of these two plates of sintered material were stacked and joined in the same way as in Embodiment 1 to produce a wafer holder. Electrode terminals in the same manner as Embodiment 1 were joined onto the wafer holder backside, to which lead lines were also joined.

This wafer holder of Al₂O₃ manufacture was set atop the same support member made of mullite as in Embodiment 1. One end of the mullite support member was clamped to the chamber. The isothermal rating of the entire surface of its wafer-holding face retaining a wafer was measured under the same conditions as in Embodiment 1, and therein was 500°C ±0.7%. Furthermore, 10 identical wafer holders were fabricated, and put through a heat-cycling test in the same way as in Embodiment 1, and yet there were no problems with any of them.

### Embodiment 3

A granulated powder was prepared by adding 2 weight % boron carbide (B₄C) as a sintering promoter to silicon carbide (SiC) powder, further dispersing and mixing an additive binder into the B₄C-containing SiC powder, and then spray-drying the mixture to granulate it. After being sintered the granulated powder was molded with a uniaxial press into 2 plates whose dimensions were 350 mm diameter × 5 mm thickness.

A resistive-heating-element circuit was imprinted onto one of the molded-material sheets with a kneaded mixture of tungsten powder to which a sintering promoter and an ethyl-cellulose binder were added. The printed molded member was then degreased within a nitrogen gas stream at 900°C, and at the same time was sintered by heating it 5 hours at 1900°C. The thermal conductivity of the SiC sintered member thus produced was 150 W/mK. The sintered member was superficially polished using diamond grit.

The remaining molded member was sintered in the same manner as noted above, and a slurry that was a kneaded mixture glass for binding, to which an ethyl-cellulose binder was added, was spread onto to the sintered remaining molded member, which was degreased within a nitrogen gas stream at 900°C. The binding-glass surface and the resistive-heating-element surface of these two plates of sintered material were stacked and joined in the same way as in Embodiment 1 to produce a wafer holder. Electrode terminals in the same manner as Embodiment 1 were joined onto the wafer holder backside, to which lead lines were also joined.

This wafer holder of SiC manufacture was set atop the same support member made of mullite as in Embodiment 1. One end of the mullite support member was clamped to the chamber. The isothermal rating of the entire surface of its wafer-holding face retaining a wafer was measured under the same conditions as in Embodiment 1, and therein was 500°C ±0.5%. Furthermore, 10 identical wafer holders were fabricated, and put through a heat-cycling test in the same way as in Embodiment 1, and yet there were no problems with any of them.

### Embodiment 4

A granulated powder was prepared by adding 2 weight % yttrium oxide (Y₂O₃) and 2 weight % aluminum oxide (Al₂O₃) as sintering promoters to silicon nitride (Si₃N₄) powder, further dispersing and mixing an additive binder into the Y₂O₃- and Al₂O₃-containing Si₃N₄ powder, and then spray-drying the mixture to granulate it. After being sintered the granulated powder was molded with a uniaxial press into 2 plates whose dimensions were 350 mm diameter × 5 mm thickness.

A resistive-heating-element circuit was imprinted onto one of the molded-material sheets with a kneaded mixture of tungsten powder to which a sintering promoter and an ethyl-cellulose binder were added. The printed molded member was then degreased within a nitrogen gas stream at 900°C, and at the same time was sintered by heating it 5 hours at 1900°C. The thermal conductivity of the Si₃N₄ sintered member thus produced was 20 W/mK. The sintered member was superficially polished using diamond grit.

The remaining molded member was sintered in the same manner as noted above, and a slurry that was a kneaded mixture glass for binding, to which an ethyl-cellulose binder was added, was spread onto to the sintered remaining molded member, which was degreased within a nitrogen gas stream at 900°C. The binding-glass surface and the resistive-heating-element surface of these two plates of sintered material were stacked and joined in the same way as in Embodiment 1 to produce a wafer holder. Electrode terminals in the same manner as Embodiment 1 were joined onto the wafer holder backside, to which lead lines were also joined.

This wafer holder of Si₃N₄ manufacture was set atop the same support member made of mullite as in Embodiment 1. One end of the mullite support member was clamped to the chamber. The isothermal rating of the entire surface of its wafer-holding face retaining a wafer was measured under the same conditions as in Embodiment 1, and therein was 500°C ±0.8%. Furthermore, 10 identical wafer holders were fabricated, and put through a heat-cycling test in the same way as in Embodiment 1, and yet there were no problems with any of them.

### Embodiment 5

The same wafer holder of AlN manufacture as in the foregoing Embodiment 1 was set on top of, without being joined to, a support member 100 mm × outside diameter × 90 mm inside diameter × 100 mm length, made of stainless steel. It will be appreciated that electrode terminals and lead lines to an end of the interior resistive heating element were likewise as with Embodiment 1 joined onto the wafer holder backside. Here, the thermal conductivity of the stainless steel was 15 W/mK.

The same evaluation as with Embodiment 1 was made on this wafer holder, wherein the isothermal rating of the wafer-holding face was 500°C ±0.42%. Furthermore, 10 identical wafer holders were fabricated, and put through a heat-cycling test in the same way as in Embodiment 1, and yet there were no problems with any of them.

### Embodiment 6

A mixture of 5 weight % Al₂O₃ powder added to the AlN powder utilized in fabricating the wafer holder in Embodiment 1, to which an extrusion binder was added, after being sintered was molded into a cylindrical form 100 mm × outside diameter × 90 mm inside diameter × 100 mm length. This was processed to make it into a support member, by degreasing it within a nitrogen gas stream at 900°C, sintering it 6 hours at 1850°C, and polishing both its ends.

A B-Si glass was spread on one end of this support member of AlN manufacture, which was joined at 800°C to the same wafer holder made of AIN (thermal conductivity: 170 W/mK; thermal expansion coefficient: 4.5 × 10⁻⁶/°C) as in Embodiment 1. The same evaluation as with Embodiment 1 was made on the wafer holder thus produced, wherein the isothermal rating was 500°C ±0.5%. Furthermore, 10 identical wafer holders were fabricated, and put through a heat-cycling test in the same way as in Embodiment 1, and yet there were no problems with any of them.

### Embodiment 7

A wafer holder of AlN manufacture and a support member of mullite manufacture that were the same as with Embodiment 1 were prepared. Both ends of the support member were polish-processed, and one end was spread with a B-Si glass and joined at 800°C to the wafer holder. The thermal expansion coefficient of the AlN and of the mullite here was 0.5 × 10⁻⁶/°C.

The same evaluation as with Embodiment 1 was made on the wafer holder thus produced, wherein the isothermal rating was 500°C ±0.43%. Furthermore, 10 identical wafer holders were fabricated, and put through a heat-cycling test in the same way as in Embodiment 1, and yet there were no problems with any of them.

### Embodiment 8

A cylindrical support member 100 mm × outside diameter × 90 mm inside diameter × 100 mm length, made of a composite material being mullite (3Al₂O₃ · 2SiO₂) to which Al₂O₃ was added to adjust the thermal expansion coefficient to be 4.5 × 10⁻⁶/°C, was prepared. Both ends of the support member were polish-processed, and one end was spread with a B-Si glass and joined at 800°C to the same wafer holder made of AlN as in Embodiment 1.

The same evaluation as with Embodiment 1 was made on the wafer holder thus produced, wherein the isothermal rating was 500°C ±0.41%. Furthermore, 10 identical wafer holders were fabricated, and put through a heat-cycling test in the same way as in Embodiment 1, and yet there were no problems with any of them.

### Embodiment 9

Wafer holders of AlN manufacture that were the same as with Embodiment 1 were prepared. For the support members, utilizing the same ingredients as in Embodiment 8, support members having the following forms were fabricated. Specifically fabricated were: one support member *a* 350 mm × outside diameter × 330 mm inside diameter × 100 mm length; and two support members *b* 10 mm × outside diameter × 9 mm inside diameter × 100 mm length.

Both ends respectively of the support member a and support members *b* were polish-processed, and one end of each was spread with a B-Si glass and joined at 800°C in nitrogen to a respective wafer holder made of AlN. Support member *a*, however, was joined to the middle of its wafer holder backside, while the two support members *b* were each joined to their wafer holder backside so as to cover the electrode terminals.

The same evaluation as with Embodiment 1 was made on the wafer holders thus produced, wherein the isothermal rating of the wafer holder on which support member a was utilized was 500°C ±0.44%, while the isothermal rating of the wafer holder on which the two support members *b* were utilized was 500°C ±0.40%. Furthermore, 10 wafer holders identical with each were fabricated, and put through a heat-cycling test in the same way as in Embodiment 1, and yet there were no problems with any of them.

### Comparative Example 1

A wafer holder of AlN manufacture was fabricated by the same method as with Embodiment 1. The support member was made of the same AlN as the wafer holder, and rendered 100 mm × outside diameter × 90 mm inside diameter × 300 mm length. The thermal conductivity of both the wafer holder and the support member was 180 W/mK. Both ends of the support member were polish-processed, and one end was spread with a B-Si glass and joined at 800°C to the wafer holder.

The same evaluation as with Embodiment 1 was made on the wafer holder thus produced, wherein the isothermal rating was 500°C ±1.5%. Furthermore, 10 identical wafer holders were fabricated, and put through a heat-cycling test in the same way as in Embodiment 1, and yet there were no problems with any of them.

### Comparative Example 2

A wafer holder and a support member were fabricated by the same method as with Comparative Example 1, apart from shortening the support-member length to 100 mm. The wafer holder and the support member both were made of AlN, and their thermal conductivity was 180 W/mK. The wafer holder and the support member were joined in the same manner as with Comparative Example 1.

The same evaluation as with Embodiment 1 was made on the wafer holder thus produced, wherein the isothermal rating was 500°C ±2.0%. Furthermore, the same wafer holder was kept at 500°C for 1 hour, whereupon the wafer holder fractured from thermal shock due to water-cooling the retaining end.

### Comparative Example 3

A wafer holder and a support member were fabricated by the same method as with Comparative Example 1. The wafer holder and the support member both were made of AlN, and their thermal conductivity was 180 W/mK. The wafer holder was set on top of, without being joined to, the support member.

The same evaluation as with Embodiment 1 was made on the wafer holder thus produced, wherein the isothermal rating was 500°C ±1.2%. Furthermore, 10 identical wafer holders were fabricated, and put through a heat-cycling test in the same way as in Embodiment 1, and yet there were no problems with any of them.

### Comparative Example 4

A wafer holder of AlN manufacture was fabricated by the same method as with Embodiment 1. For the support member, a100 mm × outside diameter × 90 mm inside diameter × 300 mm length support member made of copper was prepared. The thermal conductivity of the wafer holder was 180 W/mK, while the thermal conductivity of the support member was 393 W/mK. Both ends of the support member were polish-processed, and the wafer holder was set on top of it without being joined to it.

The same evaluation as with Embodiment 1 was made on the wafer holder thus produced, wherein the isothermal rating was 500°C ±2.5%. Furthermore, 10 identical wafer holders were fabricated, and put through a heat-cycling test in the same way as in Embodiment 1, and yet there were no problems with any of them.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A retaining member for use in a semiconductor manufacturing apparatus, composed of a wafer holder made of a ceramic having a resistive heating element, and a support member for supporting said wafer holder; **characterized in that** the thermal conductivity of said support member is lower than the thermal conductivity of said wafer holder.

2. The semiconductor-manufacturing-apparatus retaining member set forth in claim 1, **characterized in that** said wafer holder and said support member either are not joined, or otherwise said wafer holder and said support member are joined and moreover the thermal expansion coefficient of the two is 2.0 × 10⁻⁶/°C or less.

3. The semiconductor-manufacturing-apparatus retaining member set forth in claim 1 or 2, **characterized in that** at least one ceramic type selected from AlN, Al₂O₃, SiC, Si₃N₄ is the principal component of said wafer holder.

4. The semiconductor-manufacturing-apparatus retaining member set forth in claim 3, **characterized in that** said wafer holder is AlN.

5. The semiconductor-manufacturing-apparatus retaining member set forth in any of claims 1 through 4, **characterized in that** mullite is the principal component of said support member.

6. The semiconductor-manufacturing-apparatus retaining member set forth in claim 5, **characterized in that** said support member is a composite of mullite and alumina.

7. A semiconductor manufacturing apparatus utilizing the semiconductor-manufacturing-apparatus retaining member set forth in any of claims 1 through 6.

8. The semiconductor manufacturing apparatus set forth in claim 7, **characterized in** being an apparatus utilized in thermosetting of photolithographic resin films, or in baking low-dielectric-constant insulating films.
